# EUROPÄISCHE PATENTSCHRIFT

(11) **EP 3 352 064 B1**
(45) Veröffentlichungstag und Bekanntmachung des Hinweises auf die Patenterteilung: **12.06.2019**
(21) Anmeldenummer: 17203556.0
(22) Anmeldetag: 24.11.2017
(51) Int. Cl.: G06F 3/044, H05B 37/02

(54) **LICHTSTELLPULT MIT BERÜHRUNGSSENSORIK**
LIGHT ADJUSTING PANEL WITH TOUCH SENSORS
CONSOLE DE RÉGLAGE DE L'ÉCLAIRAGE DOTÉE DU CAPTEUR TACTILE

(30) Priorität: 18.01.2017 DE 202017100248 U
(43) Veröffentlichungstag der Anmeldung: 25.07.2018
(73) Patentinhaber: MA Lighting Technology GmbH, 97297 Waldbüttelbrunn (DE)
(72) Erfinder: ADENAU, Michael, 97082 Würzburg (DE)
(74) Vertreter: advotec.

(56) Entgegenhaltungen:
- EP-A2- 1 784 058
- DE-A1-102006 044 478
- DE-U1-202016 105 915
- US-A1- 2013 314 369
- US-B1- 9 402 291

## Beschreibung

Die Erfindung betrifft ein Lichtstellpult mit einem Konsolengehäuse und einem daran befestigten Schieberegler nach dem Oberbegriff des Anspruchs 1.

Gattungsgemäße Lichtstellpulte dienen zur Steuerung von Beleuchtungsanlagen, wie sie beispielsweise bei Konzertbühnen oder in Theatern zum Einsatz kommen. Diese Beleuchtungsanlagen umfassen regelmäßig eine Vielzahl von Beleuchtungseinrichtungen, beispielsweise Bühnenscheinwerfer, wobei die Beleuchtungseinrichtungen vielfach auch noch für sich genommen zwischen einer Vielzahl von Beleuchtungszuständen, beispielsweise unterschiedlichen Farben, umgestellt werden können. Diese unterschiedlichen Beleuchtungszustände der jeweils an das Lichtstellpult angeschlossenen Beleuchtungseinrichtungen können durch programmierte Parameter im Beleuchtungsprogramm des Lichtstellpults gesteuert werden. Übliche Beleuchtungsanlagen können dabei bis zu mehrere Tausend Beleuchtungseinrichtungen umfassen. Um derart komplexe Beleuchtungsanlagen steuern zu können, sind die gattungsgemäßen Lichtstellpulte mit einem Digitalprozessor ausgestattet, der eine digitale Daten- und Signalverarbeitung erlaubt. Zur Speicherung der Steuerdaten ist regelmäßig ein Digitalspeicher vorgesehen, der es insbesondere ermöglicht, Beleuchtungsprogramme zu speichern bzw. zu archivieren. Zum Schutz der elektrischen und elektronischen Bauteile des Lichtstellpults sind die entsprechenden Komponenten in einem Konsolengehäuse eingebaut, das die elektrischen und elektronischen Komponenten des Lichtstellpults nach außen hin abschirmt.

Zur Programmierung des Beleuchtungsprogramms bzw. zur Steuerung des Beleuchtungsprogramms während eines Programmablaufs müssen vom Bediener Bedienbefehle als Eingabewerte eingegeben werden. Dabei kann es sich beispielsweise um die Auswahl einer bestimmten Beleuchtungseinrichtung bzw. um die Einstellung eines bestimmten Parameters handeln. Für die Eingabe dieser Bedienbefehle sind an bekannten Lichtstellpulten mechanische Bedienelemente, wie Taster, Drehregler (Encoder) oder Schieberegler, vorhanden, die an der Oberseite des Konsolengehäuses in einem Bedienfeld angeordnet sind. Die den einzelnen Bedienelementen zugeordneten Bedienbefehle können dabei durch geeignete Menüumschaltungen verändert werden, um entsprechend komplexe Beleuchtungsprogramme programmieren und steuern zu können.

Insbesondere die Schieberegler sind bei der Programmierung der Beleuchtungsprogramme von großer Bedeutung. Die Schieberegler umfassen dabei einen Bedienknopf, der an der Oberseite des Lichtstellpults über das Konsolengehäuse übersteht und vom Benutzer zur Einstellung bestimmter Programmierparameter linear verschoben werden kann. Im Konsolengehäuse selbst ist für jeden Schieberegler ein Schlitz vorgesehen, durch den der Bedienknopf an der Außenseite des Konsolengehäuses mit den im Konsolengehäuse selbst eingebauten Schiebereglern verbunden ist. Aus der US 9 402 291 B1 ist ein gattungsgemäßes Lichtstellpult bekannt, bei dem im Bedienfeld des Lichtsteuerpultes mindestens ein Schieberegler vorgesehen ist, der die Steuerung einer Beleuchtungsanlage durch lineare Verstellung eines Bedienknopfes ermöglicht. Zur Unterstützung des Bedieners, insbesondere in abgedunkelten Umgebungen, wird in der US 9 402 291 B1 eine Beleuchtung des Bedienknopfs vorgeschlagen, indem im Gehäuse des Lichtstellpults eine Lichtquelle vorzusehen ist und das Licht durch ein lichtleitendes Element von der Lichtquelle zu einem am Bedienknopf angeordneten Lichtaustritt übertragen wird.

Aufgrund der Vielzahl von Bedienelementen an bekannten Konsolengehäusen erfordert die Programmierung von Beleuchtungsprogrammen viel Erfahrung und ein hohes Maß an Konzentration. Aufgabe der vorliegenden Erfindung ist es deshalb, ein neues Lichtstellpult vorzuschlagen, das den Benutzer während der Programmierung und während des Einsatzes des Lichtstellpults durch geeignete Assistenzmaßnahmen unterstützt.

Diese Aufgabe wird durch ein Lichtstellpult nach der Lehre des Anspruchs 1 gelöst.

Vorteilhafte Ausführungsformen der Erfindung sind Gegenstand der Unteransprüche.

Das erfindungsgemäße Lichtstellpult beruht auf dem Grundgedanken, dass an dem Schieberegler eine Berührungssensorik vorgesehen ist, mit der Berührungen des Benutzers am Bedienknopf detektierbar sind. Dadurch wird es ermöglicht, dass bestimmte Assistenzmaßnahmen, beispielsweise das Einblenden von bestimmten Menüs, automatisch von der Steuerung ausgelöst werden, sobald der Benutzer den Bedienknopf berührt.

In welcher Weise die Berührungssensorik konstruktiv ausgebildet ist, ist grundsätzlich beliebig. Besonders einfach lässt sich die Berührungssensorik realisieren, wenn der Bedienknopf aus einem elektrisch leitenden Material hergestellt ist. Sobald der Benutzer den Bedienknopf dann berührt, können durch geeignete elektronische Auswerteeinrichtungen die durch die Berührung am Bedienknopf ausgelösten Änderungen der elektrischen Eigenschaften einfach detektiert werden.

Besonders einfach lässt sich die Berührungssensorik realisieren, wenn die durch die Berührungen des Benutzers am Bedienknopf verursachte kapazitive Änderung detektierbar ist.

Um dem Nutzer die gewohnte Berührungshaptik am Bedienknopf des Schiebereglers bieten zu können und zugleich eine einfache elektrische Auswertung der Berührung des Benutzers am Bedienknopf vornehmen zu können, ist es besonders vorteilhaft, wenn der Bedienknopf aus einem elektrisch leitenden Kunststoff hergestellt ist.

Im Hinblick auf die Vermeidung von Störungen des Lichtstellpults ist es von großer Bedeutung, dass das Eindringen von Fremdkörpern und Staub in das Gehäuse des Schiebereglers möglichst vermieden wird. Insbesondere bei Schiebereglern, die einen Schleifkontakt beinhalten, stellt Staub nämlich eine große Gefahr für die Funktionalität des Schiebereglers dar. Um das Eindringen von Staub in das Gehäuse des Schiebereglers weitgehend zu minimieren und zugleich die Bewegungen des Bedienknopfs auf den Schleifkontakt übertragen zu können, kann das Gehäuse des Schiebereglers einen Schlitz aufweisen, der von einem Kopplungselement, das den Bedienknopf mit dem Schleifkontakt verbindet, durchgriffen wird. Dieses Kopplungselement sollte bevorzugt ebenfalls aus einem elektrisch leitenden Material hergestellt sein, um die elektrischen Signale vom Bedienknopf in das Innere des Gehäuses des Schiebereglers übertragen zu können, wo eine entsprechende Auswertesensorik angeschlossen sein kann.

In welcher Weise der elektrische Kontakt zwischen dem aus einem elektrisch leitenden Material hergestellten Bedienknopf einerseits und dem aus einem elektrisch leitenden Material hergestellten Kopplungselement andererseits hergestellt wird, ist grundsätzlich beliebig. Besonders einfach kann dies dadurch geschehen, dass der Bedienknopf eine Vertiefung aufweist, mit der der Bedienknopf unter Bildung eines elektrischen Kontakts auf das Kopplungselement aufsteckbar ist.

Um das Eindringen von Staub und Fremdkörpern in das Innere des Gehäuses des Schiebereglers weitgehend auszuschließen, ist es besonders vorteilhaft, dass die vom Schlitz im Gehäuse des Schiebereglers gebildete Öffnung horizontal zur Seite des Lichtstellpults oder vertikal zum Boden des Lichtstellpults weist. Durch diese horizontale Ausrichtung bzw. durch die nach unten weisende Ausrichtung der Öffnung im Gehäuse des Schiebereglers wird vermieden, dass Staub und Fremdkörper unter Schwerkrafteinfluss durch die Öffnung in das Gehäuse des Schiebereglers gelangen.

Um den Schieberegler alternativ zur manuellen Bedienung auch fernsteuern zu können, ist es besonders vorteilhaft, wenn am Schieberegler ein elektrischer Antriebsmotor vorgesehen ist, mit dem der Schieberegler motorisch antreibbar ist. Auf diese Weise können Einstellungen des Schiebereglers auch ferngesteuert angefahren werden.

Im Hinblick auf eine elektrische Kontaktierung des Schiebereglers mit den anderen elektronischen Bauteilen des Lichtstellpults ist es besonders vorteilhaft, wenn der Schieberegler einen Steckkontakt mit mehreren Kontaktelementen umfasst. Auf diesen Steckkontakt kann dann ein funktionskomplementärer Stecker aufgesteckt werden, um auf diese Weise mit einer einzigen Montagebewegung den gesamten Schieberegler elektrisch im Lichtstellpult anzuschließen.

Im Hinblick auf die elektrische Funktionalität ist es besonders vorteilhaft, wenn der Steckkontakt auf einer Elektronikplatine des Schiebereglers befestigt ist.

Soweit der Schieberregler eine Elektronikplatine mit Steckkontakt aufweist, sollte der Antriebsmotor des Schiebereglers bevorzugt über die Elektronikplatine elektrisch kontaktiert werden.

Eine Ausführungsform der Erfindung ist in den Zeichnungen schematisch dargestellt und wird nachfolgend beispielshaft erläutert.

Es zeigen:
- **Fig. 1**: ein Lichtstellpult zur Steuerung einer Beleuchtungsanlage mit mehreren Schiebereglern in Ansicht von oben;
- **Fig. 2**: einen der Schieberegler des Lichtstellpults gemäß Fig. 1 in demontiertem Zustand in perspektivischer seitlicher Ansicht;
- **Fig. 3**: den Schieberegler gemäß Fig. 2 nach Demontage des Bedienknopfs in seitlicher Ansicht;
- **Fig. 4**: den Schieberegler gemäß Fig. 2 im Querschnitt.

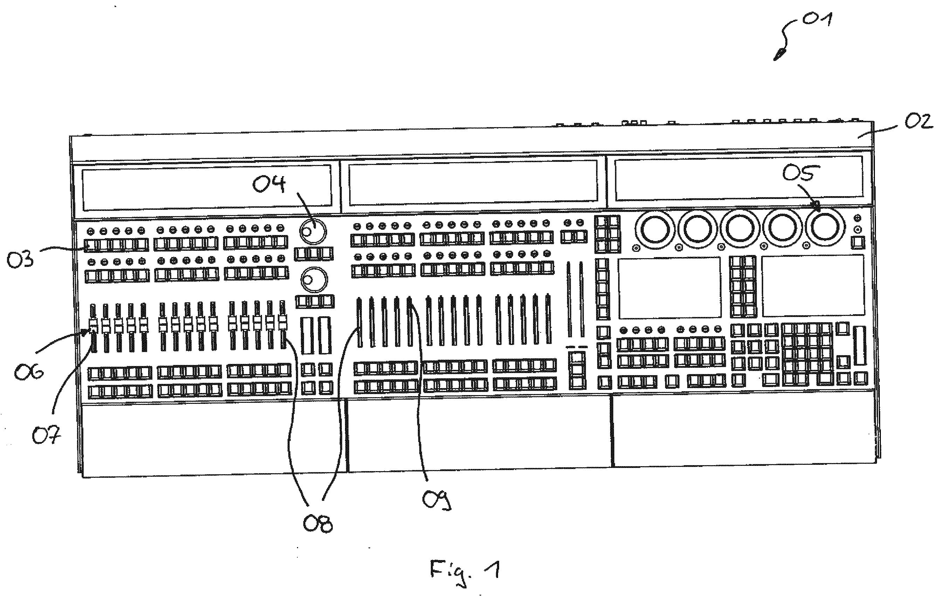

**Fig. 1** zeigt ein Lichtstellpult 01 zur Steuerung einer ansonsten nicht dargestellten Beleuchtungsanlage von oben. Zur Eingabe von Bedienbefehlen des Benutzers bei der Programmierung von Beleuchtungsprogrammen ist in das Konsolengehäuse 02 eine Vielzahl von mechanischen Bedienelementen wie Taster 03, Drehregler 04, Doppelwellenencoder 05 und Schieberegler 06, eingebaut. In der Darstellung gemäß Fig. 1 sind von den Schiebereglern 06 nur die über die Oberseite des Konsolengehäuses 02 überstehenden Teile, nämlich die Bedienknöpfe 07 oder die bei Demontage der Bedienknöpfe 07 durch Schlitze 08 überstehenden Kopplungselemente 09, erkennbar.

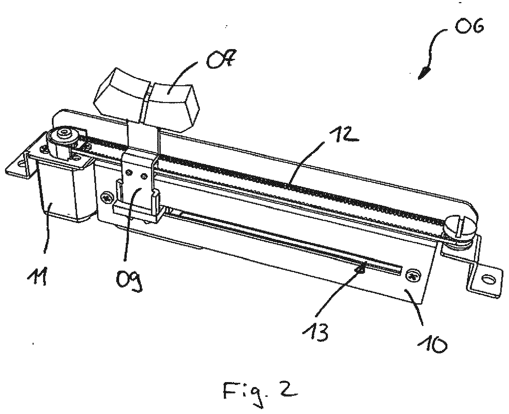

**Fig. 2** zeigt einen Schieberegler 06 mit dem auf das Kopplungselement 09 aufgesteckten Bedienknopf 07 in perspektivischer Ansicht. Der Bedienknopf 07 und das Kopplungselement 09 sind jeweils aus einem elektrisch leitenden Material hergestellt. So besteht der Bedienknopf 07 aus einem elektrisch leitenden Kunststoff und das Kopplungselement 09 aus Metall. Dadurch können elektrische Signale durch den Bedienknopf 07 und das Kopplungselement 09 übertragen werden. Sobald ein Benutzer den Bedienknopf 07 mit den Fingern berührt, ändern sich dadurch die elektrischen Eigenschaften, wobei diese Änderungen durch entsprechende Signale von einer in das Gehäuse 10 des Schiebereglers 06 integrierten Berührungssensorik ausgewertet werden können.

Der Schieberegler 06 ist mit einem Antriebsmotor 11 ausgestattet, der über einen Antriebsriemen 12 das Kopplungselement 09 antreiben kann. Auf diese Weise kann der Schieberegler 06 nicht nur manuell verstellt werden, sondern auch durch Fernsteuerung des Antriebsmotors 11.

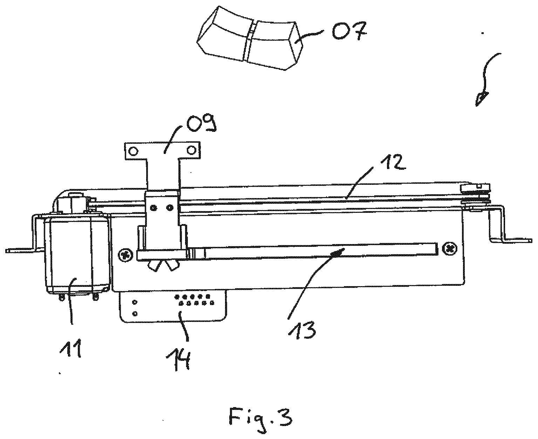

**Fig. 3** zeigt den Schieberegler 06 bei abgenommenem Bedienknopf 07 in seitlicher Ansicht. Das Gehäuse 10 des Schiebereglers 06 weist einen Schlitz 13 auf, der vom Kopplungselement 09 von außen her durchgriffen wird, um auf diese Weise das im Inneren des Gehäuses 10 angeordnete Schleifelement und die im Inneren des Gehäuses 10 angeordnete Berührungssensorik mit dem außerhalb des Gehäuses 10 zulaufenden Teil des Kopplungselements 09 und insbesondere auch mit dem Bedienknopf 07 verbinden zu können. Die elektronischen Bauteile des Schiebereglers 06 sind auf einer Elektronikplatine 14 verbaut.

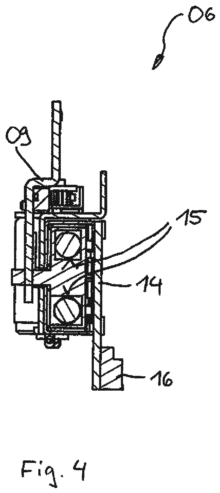

**Fig. 4** zeigt den Schieberegler 06 im Querschnitt. Man erkennt das Kopplungselement 09 und den im Inneren des Gehäuses 10 eingebauten Schleifkontakt 15, über den auch die Berührungssensorik kontaktiert ist. Der Schleifkontakt 15 ist seinerseits über die Elektronikplatine 14 kontaktiert und kann vermittelt über einen Steckkontakt 16 durch Aufstecken eines Steckers mit der Elektronik des Lichtstellpults 01 verbunden werden.

## Patentansprüche

1. Lichtstellpult (01) zur Steuerung einer Beleuchtungsanlage, wobei im Lichtstellpult (01) digitale Stellbefehle erzeugt werden, die über Datenverbindungen an die Beleuchtungseinrichtungen der Beleuchtungsanlage übertragen werden können, wobei das Lichtstellpult (01) zumindest einen Digitalprozessor und zumindest einen Digitalspeicher zur Erzeugung, Verwaltung und Speicherung der Stellbefehle umfasst, und wobei der Digitalprozessor und der Digitalspeicher in einem Konsolengehäuse (02) angeordnet sind, und wobei das Lichtstellpult (01) zumindest einen Schieberegler (06) umfasst, an dem vom Benutzer durch lineare Verschiebung eines über die Oberseite des Konsolengehäuses (02) überstehenden Bedienknopfs (07) Bedienbefehle eingegeben werden können, und wobei die Oberseite des Konsolengehäuses (02) für jeden Schieberegler (06) einen Schlitz (08) aufweist, durch den der Bedienknopf (07) mit dem Schieberegler (06) verbunden ist,
**dadurch gekennzeichnet,**
**dass** am Schieberegler (06) eine Berührungssensorik vorgesehen ist, mit der die Berührungen des Benutzer am Bedienknopf (07) detektierbar sind, wobei der aus einem elektrisch leitenden Material hergestellte Bedienknopf (07) durch ein aus einem elektrisch leitenden Material hergestelltes Kopplungselement (09) mit dem Schieberegler (06) elektrisch kontaktiert ist.

2. Lichtstellpult nach Anspruch 1,
**dadurch gekennzeichnet,**
**dass** mit der Berührungssensorik die durch die Berührungen des Benutzers am Bedienknopf (07) verursachte kapazitive Änderung detektierbar ist.

3. Lichtstellpult nach Anspruch 1 oder 2,
**dadurch gekennzeichnet,**
**dass** der Bedienknopf (07) aus einem elektrisch leitenden Kunststoff hergestellt ist.

4. Lichtstellpult nach einem der Ansprüche 1 bis 3,
**dadurch gekennzeichnet,**
**dass** im Gehäuse (10) des Schiebereglers (06) zumindest ein Schleifkontakt (15) vorgesehen ist, wobei das Gehäuse (10) des Schiebereglers (06) einen Schlitz (13) aufweist, der von dem Kopplungselement (09) durchgriffen wird und den Bedienknopf (07) mit dem Schleifkontakt (15) verbindet.

5. Lichtstellpult nach einem der Ansprüche 1 bis 4,
**dadurch gekennzeichnet,**
**dass** der Bedienknopf (07) eine Vertiefung aufweist, mit der der Bedienknopf (07) unter Bildung eines elektrischen Kontakts auf das Kopplungselement (09) aufsteckbar ist.

6. Lichtstellpult nach einem der Ansprüche 1 bis 5,
**dadurch gekennzeichnet,**
**dass** die vom Schlitz (13) im Gehäuse (10) des Schiebereglers (06) gebildete Öffnung horizontal zur Seite des Lichtstellpults (01) oder vertikal zum Boden des Lichtstellpults (01) weist.

7. Lichtstellpult nach einem der Ansprüche 1 bis 6,
**dadurch gekennzeichnet,**
**dass** am Schieberegler (06) ein elektrischer Antriebsmotor (11) vorgesehen ist, mit dem der Schieberegler (06) motorisch antreibbar ist.

8. Lichtstellpult nach einem der Ansprüche 1 bis 7,
**dadurch gekennzeichnet,**
**dass** der Schieberegler (06) einen Steckkontakt (16) mit mehreren Kontaktelementen umfasst, an dem ein funktionskomplementärer Stecker zur elektrischen Kontaktierung des Schiebereglers (06) mit dem Lichtstellpult (01) aufgesteckt werden kann.

9. Lichtstellpult nach Anspruch 8,
**dadurch gekennzeichnet,**
**dass** der Steckkontakt (16) auf einer Elektronikplatine (14) des Schiebereglers (06) befestigt ist.

10. Lichtstellpult nach Anspruch 9,
**dadurch gekennzeichnet,**
**dass** der Antriebsmotor (11) zur elektrischen Kontaktierung mit der Elektronikplatine (14) des Schiebereglers (06) verbunden ist.

## Claims

1. A lighting control console (01) for controlling a lighting system, digital adjusting commands being generated in the lighting control console (01), said adjusting commands being able to be transmitted to the lighting devices of the lighting system via data links, said lighting control console (01) comprising at least one digital processor and at least one digital memory for generating, managing and storing the adjusting commands, and said digital processor and said digital memory being arranged in a console housing (02), and said lighting control console (01) comprising at least one slide control (06) at which operating commands can be input by the user via linear displacement of a control knob (07) protruding from the upper side of the console housing (02), and said upper side of the console housing (02) comprising a slit (08) for each slide control (06), said control knob (07) being connected to said slide control (06) via said slit (08),
**characterised in that**
a tactile sensor system, by means of which it can be detected when the user touches the control knob (07), is provided at the slide control (06), wherein the control knob (07) made of an electrically conductive material is electrically contacted to the slide control (06) via a coupling element (09) made of an electrically conductive material.

2. The lighting control console according to claim 1,
**characterised in that**
the capacitive change caused by the user touching the control knob (07) can be detected using the tactile sensor system.

3. The lighting control console according to claim 1 or 2,
**characterised in that**
the control knob (07) is made of an electrically conductive plastic.

4. The lighting control console according to any one of the claims 1 to 3,
**characterised in that**
at least one sliding contact (15) is provided in the housing (10) of the slide control (06), said housing (10) of the slide control (06) comprising a slit (13) through which the coupling element (09) is passed and which connects the control knob (07) to the sliding contact (15).

5. The lighting control console according to any one of the claims 1 to 4,
**characterised in that**
the control knob (07) comprises an indentation by means of which the control knob (07) can be plugged onto the coupling element (09) thus forming an electric contact.

6. The lighting control console according to any one of the claims 1 to 5,
**characterised in that**
the opening formed in the housing (10) of the slide control (06) by the slit (13) is oriented horizontally to the side of the lighting control console (01) or vertically to the bottom of the lighting control console (01).

7. The lighting control console according to any one of the claims 1 to 6,
**characterised in that**
an electric drive motor (11) is provided at the slide control (06), by means of which (11) the slide control (06) can be motor-driven.

8. The lighting control console according to any one of the claims 1 to 7,
**characterised in that**
the slide control (06) comprises a plug contact (16) having several contact elements, a plug complementary in function being able to be plugged onto said plug contact (16) for electrically contacting the slide control (06) to the lighting control console (01).

9. The lighting control console according to claim 8,
**characterised in that**
the plug contact (16) is fastened on an electronic circuit board (14) of the slide control (06).

10. The lighting control console according to claim 9,
**characterised in that**
the drive motor (11) is connected to the electronic circuit board (14) of the slide control (06) for producing an electric contact.

## Revendications

1. Pupitre de commande d'éclairage (01) pour commander un système d'éclairage, des instructions de réglage numériques qui peuvent être transmises aux dispositifs d'éclairage du système d'éclairage par des liaisons de données étant générées dans le pupitre de commande d'éclairage (01), ledit pupitre de commande d'éclairage (01) comprenant au moins un processeur numérique et au moins une mémoire numérique pour générer, gérer et stocker les instructions de réglage, et ledit processeur numérique et ladite mémoire numérique étant disposés dans un boîtier de console (02), et ledit pupitre de commande d'éclairage (01) comprenant au moins un curseur (06), les utilisateurs pouvant entrer des instructions de commande moyennant un déplacement linéaire d'un bouton de manoeuvre (07) débordant sur le côté supérieur du boîtier de console (02), et ledit côté supérieur du boîtier de console (02) présentant, pour chaque curseur (06), une fente (08) moyennant laquelle le bouton de manoeuvre (07) est relié avec le curseur (06),
**caractérisé en ce**
**qu'**un système capteur tactile est prévu au curseur (06), à l'aide duquel les contacts des utilisateurs au bouton de manoeuvre (07) peuvent être détectés, ledit bouton de manoeuvre (07) qui est fabriqué à base d'un matériau électroconducteur étant contacté électriquement avec le curseur (06) moyennant un élément de couplage (09) qui est fabriqué à base d'un matériau électroconducteur.

2. Pupitre de commande d'éclairage selon la revendication 1,
**caractérisé en ce que**
la variation capacitive qui est provoquée par les contacts des utilisateurs au bouton de manoeuvre (07) peut être détectée à l'aide du système capteur tactile.

3. Pupitre de commande d'éclairage selon la revendication 1 ou 2,
**caractérisé en ce que**
le bouton de manoeuvre (07) est fabriqué à base d'une matière plastique électroconductrice.

4. Pupitre de commande d'éclairage selon l'une quelconque des revendications 1 à 3,
**caractérisé en ce que**
dans le boîtier (10) du curseur (06), au moins un contact frotteur (15) est prévu, ledit boîtier (10) du curseur (06) présentant une fente (13), l'élément de couplage (09) pénétrant ladite fente qui relie le bouton de manoeuvre (07) avec le contact frotteur (15).

5. Pupitre de commande d'éclairage selon l'une quelconque des revendications 1 à 4,
**caractérisé en ce que**
le bouton de manoeuvre (07) présente un évidement à l'aide duquel le bouton de manoeuvre (07) peut être fixé sur l'élément de couplage (09), en formant un contact électrique.

6. Pupitre de commande d'éclairage selon l'une quelconque des revendications 1 à 5,
**caractérisé en ce que**
l'ouverture qui est constituée par la fente (13) dans le boîtier (10) du curseur (06) est orientée horizontalement vers le côté du pupitre de commande d'éclairage (01) ou verticalement vers le fond du pupitre de commande d'éclairage (01).

7. Pupitre de commande d'éclairage selon l'une quelconque des revendications 1 à 6,
**caractérisé en ce**
**qu'**un moteur d'entraînement (11) électrique est prévu au curseur (06) à l'aide duquel le curseur (06) peut être entraîné par moteur.

8. Pupitre de commande d'éclairage selon l'une quelconque des revendications 1 à 7,
**caractérisé en ce que**
le curseur (06) comprend un contact à fiches (16) ayant plusieurs éléments de contact, sur lequel une fiche mâle complémentaire en matière de fonction peut être fixée pour contacter le curseur (06) avec le pupitre de commande d'éclairage (01) électriquement.

9. Pupitre de commande d'éclairage selon la revendication 8,
**caractérisé en ce que**
le contact à fiches (16) est attaché sur une platine électronique (14) du curseur (06).

10. Pupitre de commande d'éclairage selon la revendication 9,
**caractérisé en ce que**
le moteur d'entraînement (11) est relié avec la platine électronique (14) du curseur (06) pour établir un contact électrique.
